# EUROPÄISCHE PATENTSCHRIFT

(11) **EP 1 410 698 B1**
(45) Veröffentlichungstag und Bekanntmachung des Hinweises auf die Patenterteilung: **16.09.2009**
(21) Anmeldenummer: 01925347.5
(22) Anmeldetag: 21.02.2001
(51) Int. Cl.: H05H 1/46, H01J 37/32, H03H 7/38

(54) **HOCHFREQUENZ-ANPANETZWERK**
HIGH-FREQUENCY MATCHING NETWORK
ADAPTATEUR D'IMPEDANCE A HAUTE FREQUENCE

(30) Priorität: 24.02.2000 DE 10008483; 24.02.2000 DE 10008484; 24.02.2000 DE 10008485; 24.02.2000 DE 10008486
(43) Veröffentlichungstag der Anmeldung: 21.04.2004
(73) Patentinhaber: C.C.R. GmbH, Beschichtungstechnologie, 53619 Rheinbreitbach (DE)
(72) Erfinder: WEILER, Manfred, 53619 Rheinbreitbach (DE); DAHL, Roland, 53545 Ockenfels (DE)
(74) Vertreter: Gesthuysen, von Rohr & Eggert
(86) Internationale Anmeldenummer: PCT/EP2001/001953
(87) Internationale Veröffentlichungsnummer: WO 2001/063982

(56) Entgegenhaltungen:
- EP-A- 0 597 497
- WO-A-99/44219
- GB-A- 2 206 251
- US-A- 4 764 773
- US-A- 5 140 223
- US-A- 5 229 911

## Beschreibung

Die Erfindung betrifft eine Vorrichtung zum Einspeisen eines hochfrequenten elektrischen Wechselfelds in eine Niederdruckgasentladung, im folgenden als Plasma bezeichnet, bei gleichzeitigem Angleich der Verbraucherimpedanz an den Innenwiderstand eines handelsüblichen Hochfrequenz-Generators, im folgenden Hochfrequenz-Anpaßnetzwerk genannt.

Hochfrequenz angeregte Plasmen finden heute in vielen technologischen Bereichen Anwendung, insbesondere jedoch in der Behandlung von Festkörperoberflächen. So werden Hochfrequenz-Plasmen z.B. zur plasmagestützten Abscheidung dünner Schichten oder zum Reinigen und Ätzen von Oberflächen eingesetzt. Beim Betrieb von Hochfrequenz-Plasmen ist die Verwendung von Impedanz-Anpaßnetzwerken notwendig um die Verbraucherimpedanz auf den Innenwiderstand des verwendeten Hochfrequenz-Generators abzustimmen. Nur wenn die Verbraucherimpedanz mit dem Innenwiderstand des Generators übereinstimmt, ist eine optimale Übertragung der Leistung von Generator zum Verbraucher möglich. In der Regel wird zwischen den Verbraucher und den Generator ein Impedanz-Anpaßnetzwerk geschaltet, welches den Angleich der beiden Impedanzen durchführt.

Anpaßnetzwerke für die Plasmaanregung erlauben nach heutigem Stand der Technik lediglich die induktive Angleichung der Verbraucherimpedanz zum Innenwiderstand des Generators, um die reflektierte Leistung zu minimieren und somit die ins Plasma eingespeiste Leistung zu optimieren. Die Ankopplung des elektrischen Wechselfeldes an das Plasma erfolgt dabei über eine Elektrode in Kontakt mit dem Plasma oder über die Einstrahlung des Feldes über ein dielektrisches Medium. Für die Anregungseffizienz des Plasmas ist von besonderer Bedeutung, ob bei der Anregung des Plasmas der kapazitive oder induktive Anteil der Anregung überwiegt. Eine kapazitive Anregung liegt dann vor, wenn die elektromagnetische Welle über die Randschicht des Plasmas eingestrahlt wird und bei ihrer Ausbreitung zum Zentrum des Plasmas hin eine exponentielle Dämpfung erfährt. Im Falle der induktiven Anregung erfolgt die Ankopplung des elektrischen Wechselfeldes über ein im Plasma induziertes magnetisches Wechselfeld. In der Regel besteht die Anregung aus einer Mischanregung mit einem kapazitiven und induktiven Anteil. Bei festgehaltener äußerer Hochfrequenz-Leistung wird der kapazitive Anteil der Plasmaankopplung durch die Spannungsamplitude und der induktive Anteil durch die Stromamplitude des an der Elektrode anliegenden elektrischen Wechselfeldes bestimmt.

Rayner, Cheetham und French haben in J. Vac. Sci. Technol. A 14(4) (Jul/Aug 1996), Seiten 2048-2055, bereits ein Hochfrequenz-Anpaßnetzwerk beschrieben, das aus zwei Schaltkreisen besteht, wobei diese über den induktiven Fluß der Hochfrequenz-Luftspulen miteinander gekoppelt sind.

GB-A-2 206 251 offenbart ein Hochfrequenz-Anpassnetzwerk mit zwei Schaltkreizen, wobei diese über den induktiven Fluss der Hochfrequenz-Spulen miteinander gekoppelt sind.

Der Erfindung liegt die Aufgabe zugrunde, ein verlustarmes Hochfrequenz-Anpaßnetzwerk zur Plasmaanregung bereitzustellen, das die freie Wahl von Strom- und Spannungsamplitude bei gleichzeitiger Angleichung der Verbraucherimpedanz an den Innenwiderstand eines Hochfrequenz-Generators ermöglicht und somit eine kontinuierliche Einstellung zwischen kapazitiver und induktiver Anregung des Plasmas erlaubt.

Erfindungsgemäß besteht das Hochfrequenz-Anpaßnetzwerk aus einem primären Schaltkreis, in den die Leistung eines Hochfrequenz-Generators eingespeist wird, mit einem beliebigen und einem variablen Kondensator und einer Hochfrequenz-Luftspule sowie einem sekundären Schaltkreis mit einem festen oder variablen Kondensator, einer Hochfrequenz-Luftspule und mindestens einer Anregungselektrode zur Erzeugung des Plasmas, wobei die Schaltkreise über den induktiven Fluß der Hochfrequenz-Luftspulen und zusätzlich kapazitiv miteinander gekoppelt sind. Es kann, bei Verwendung eines variablen Kondensators im Sekundärkreis kontinuierlich, zwischen kapazitiver und induktiver Plasmaankopplung gewählt werden.

Der Grad der kapazitiven Kopplung zwischen dem Primär- und dem Sekundärkreis läßt sich durch einen oder mehrere Fest-Kondensatoren oder einen variablen Kondensator einstellen. Als Kondensator kann beispielsweise ein Hochfrequenz-Luftkondensator aus einem unedlen Metall mit geringem elektrischen Widerstand verwendet werden, der an der Oberfläche mit einer Schicht aus Gold oder einem Platinmetall, z.B. Platin, versehen ist, wie in der deutschen Patentanmeldung "Hochfrequenz-Luftkondensator" mit dem amtlichen Aktenzeichen 100 08 483.4 der Firma CCR GmbH Beschichtungstechnologie beschrieben. Der Hochfrequenz-Luftkondensator kann als Plattenkondensator, Zylinderkondensator oder Kugelkondensator ausgebildet sein. Vorzugsweise ist der Kondensator als Trimmer ausgebildet, z.B. als Differential-Luftplattentrimmer, insbesondere mit einer multi-linearen Kennlinie, wie in der deutschen Patentanmeldung "Differential-Luftplattentrimmer mit multi-linearer Kennlinie" mit dem amtlichen Aktenzeichen 100 08 486.9 der Firma CCR GmbH Beschichtungstechnologie beschrieben.

Ein solcher Differential-Luftplattentrimmer, mit dem aufgrund der multi-linearen Kennlinie einfache funktionale Abhängigkeiten besser angepaßt werden können, weist im Gegensatz zu linearen Luftplattentrimmern eine Kombination von herkömmlichen und segmentierten Stator- und/oder Rotorplatten auf. Bei herkömmlichen Differential-Luftplattentrimmern werden nur Stator- und Rotorplatten eingesetzt, die einem 180°-Kreissegment oder einem Rechteck mit Seitenverhältnis 2:1 ähnlich sind, wodurch der Trimmer lediglich eine lineare Kennlinie erhält. Der bevorzugte Differential-Luftplattentrimmer hingegen wird zusätzlich auch aus kreis- oder rechteckförmigen Segmenten mit Winkeln < 180° bestückt. Er erhält dadurch eine multi-lineare Kennlinie, d.h. die Kennlinie setzt sich aus Teilgeraden unterschiedlicher Steigung zusammen. Zur Darstellung einer n-fach-linearen Abhängigkeit wird zusätzlich zu den herkömmlichen Trimmerplatten eine Anzahl von n - 1 unterschiedlich segmentierten Platten benötigt. Die notwendige Plattenanzahl des jeweiligen Segmenttyps muß der jeweils darzustellenden Abhängigkeit angepaßt werden. Die gewünschte Abhängigkeit kann allgemein um so genauer angenähert werden, je höher die Anzahl der unterschiedlichen Segment-Typen ist. Die Kennlinie des bevorzugten multi-linearen Differential-Luftplattentrimmers kann somit sehr gut an einfache funktionale Abhängigkeiten angepaßt werden. Vorteilhafterweise liegt den segmentierten Rotorplatten nur eine Statorseite gegenüber. Den segmentierten Statorplatten braucht keine Statorseite gegenüberliegen. Die Statorplatten und/oder die Rotorplatten können als herkömmliche 180°-Segmente ausgebildet sein.

Im Falle der kapazitiven Kopplung kann über die Variation der Hochfrequenz-Amplitude der Spannungsabfall über die Plasmarandschicht und somit das Plasmapotential in Bezug auf das Erdpotential variiert werden. Über die Variation der Hochfrequenz-Amplitude kann somit die Energie der Ionen eingestellt werden, da die Energie der Ionen vom Plasmapotential bestimmt wird. Wird anstelle eines gewöhnlichen Trimmers der genannte multi-lineare Differential-Luftplattentrimmer eingesetzt, so ist bei der Variation des Plasmapotentials ein nachträgliches Anpassen der Resonanzkreise über die Variation der kapazitiven Kopplung nicht mehr erforderlich. Die Ionenenergie kann somit sehr einfach durch nur einen einzigen Trimmer eingestellt werden. Ist eine kontinuierlich einstellbare Ionenenergie nicht erforderlich, so kann der Differential-Trimmer durch Festkondensatoren ersetzt werden.

Die Resonanzfrequenz von Primär- und Sekundärkreis kann auf die Generatorfrequenz über einen Primär- sowie einen Sekundär-Trimmer angepaßt werden und/oder durch Variation der induktiven Kopplung zwischen Primär- und Sekundärspule, insbesondere durch Variation des axialen und radialen Abstandes zwischen den Spulen. Parallel zu den Trimmern können zusätzlich Fest-Kondensatoren geschaltet werden. Idealerweise ist der Primärkreis derart dimensioniert, daß hohe Spannungsamplituden (Spannungsresonanz) erreicht werden, und der Sekundärkreis derart, daß hohe Stromamplituden (Stromresonanz) erreicht werden.

Als Hochfrequenz-Luftspulen werden insbesondere kühlbare Hochfrequenz-Luftspulen in Form eines Rohres aus einem unedlen Metall mit geringem elektrischem Widerstand verwendet, die mindestens an ihrer äußeren Oberfläche mit einer Schicht aus Gold oder einem Platinmetall, z.B. Platin, versehen sind, wie in der deutschen Patentanmeldung "Kühlbare Hochfrequenz-Luftspule" mit dem amtlichen Aktenzeichen 100 08 484.2 der Firma CCR GmbH Beschichtungstechnologie beschrieben. Das Rohr kann einen beliebigen Querschnitt haben. Dieser ist nicht auf eine Kreisform festgelegt, sondern kann auch quadratisch oder rechteckförmig ausfallen. Zur Kühlung wird die Hochfrequenz-Luftspule von einem flüssigen Medium, vorzugsweise mit Wasser, durchspült. Die Spule kann schrauben- oder spiralförmig gewickelt sowie im letzteren Fall gleichzeitig sphärisch gewölbt sein. Der Durchmesser der Spulen liegt vorzugsweise zwischen 10 und 100 mm.

Zur Erzeugung der Stromresonanz im Sekundärkreis sollte die Gesamtinduktivität dieses Kreises möglichst gering sein. Die Sekundärspule wird deshalb auf ein Minimum an Wicklungen reduziert, vorzugsweise auf nur eine Windung. Zur Erzeugung der Spannungsresonanz im Primärkreis sollte die Induktivität dieses Kreises möglichst groß sein. Daher besteht die Primärspule aus mehreren, vorzugsweise aus 2 bis 10, Wicklungen. Der Durchmesser der Spulen sollte zwischen 10 und 100 mm liegen.

Die Anregungselektrode zur Plasmaanregung kann sowohl innerhalb des Vakuums als auch außerhalb angeordnet sein. Ist die Anregungselektrode im Vakuum angeordnet, kann sie mit dem atmosphärenseitigen Teil des Sekundärkreises über Vakuumstromdurchführungen verbunden sein. Es kann auch der gesamte aus Trimmer, Spule, Anregungselektrode sowie den Verbindungselementen bestehende Sekundärkreis im Vakuum angeordnet sein, wobei der Sekundär-Trimmer durch eine mechanische Vakuumdurchführung einstellbar ist. Zwischen den beiden Kopplungsspulen kann ein dielektrisches Fenster aus einem unmagnetischen und magnetisch durchlässigen Material zur Trennung des Vakuums von der Atmosphäre dienen. Ein solches Fenster kann aus Kunststoff, z.B. Teflon, aus Glas, z.B. Quarz- oder Fensterglas, sowie aus Keramik oder Aluminiumoxid bestehen.

Das erfindungsgemäße Impedanz-Anpaßnetzwerk kann in Verbindung mit allen möglichen und beliebigen Anregungselektroden zur Plasmaanregung verwendet werden. Es bestehen keinerlei Restriktionen bzgl. Form, Geometrie, Material, Anordnung, Anzahl etc. der Anregungselektrode.

Um eine möglichst hohe Stromamplitude bei fest gehaltener Hochfrequenz-Leistung zu erzielen, müssen weiterhin alle Komponenten des Anpaßnetzwerkes so gestaltet sein, daß möglichst geringe ohmsche Leistungsverluste auftreten. Üblicherweise bestehen einzelne oder alle hochfrequenz-führenden Komponenten von Anpaßnetzwerken, insbesondere Verbindungselemente, Leiterbahnen, Hochfrequenz-Luftspulen, Kondensatoren, Vakuumstromdurchführungen und Anregungsspulen, aus einem Metall mit geringem elektrischen Widerstand. Aus wirtschaftlichen Gründen werden üblicherweise unedle Metalle, z.B. Kupfer, Eisen, Zink, Aluminium oder deren Legierungen wie z.B. Messing, gewählt.

Allerdings fließt bei den hier angestrebten Frequenzen zwischen 1 und 50 MHz der Strom aufgrund des Skineffekts lediglich an der Oberfläche des Leiters über eine Randschicht mit einer Dicke von einigen Mikrometern. Bei herkömmlichen Leitermaterialien, wie z.B. Kupfer, reagiert die Oberfläche des Leiters durch den Kontakt mit dem Sauerstoff oder dem Stickstoff der Luft und es bildet sich eine Oxid- oder Nitridschicht auf der Oberfläche aus, welche die Leitfähigkeit an der Oberfläche des Leiters beträchtlich vermindert und somit die ohmschen Verluste für Hochfrequenz beträchtlich erhöht. Es sollte dafür gesorgt werden, daß die Leitfähigkeit der Oberfläche erhalten bleibt. Das kann durch das Beschichten einzelner oder aller hochfrequenz-führenden Komponenten mindestens an ihrer äußeren Oberfläche mit einer Schicht aus Gold oder einem Platinmetall, z.B. Platin, geschehen.

Werden Edelmetalle, z.B. Gold oder Platin, auf unedle Metalle, z.B. Kupfer oder Messing, aufgebracht, so besteht die Gefahr, daß das Edelmetall in das Trägermaterial oder das Trägermaterial in das Edelmetall hineindiffundiert. Das hat zur Folge, daß die Leitfähigkeit an der Oberfläche aus den für das unedle Metall genannten Gründen abnimmt. Der Diffusionsvorgang kann mittels einer Diffusionssperre, z.B. einer hauchdünnen Schicht aus Nickel, verhindert werden, die vor dem Aufbringen der Schicht aus Gold oder dem Platinmetall auf das unedle Metall aufgetragen wird. Somit ist die Langzeitstabilität der äußeren Metallschicht sichergestellt. Beide Schichten können plasmachemisch oder galvanisch und vorzugsweise als geschlossene Schicht einer Dicke von 10 nm bis 10 µm, vorzugsweise 1 µm, aufgebracht sein.

Die beiden Schichten, d.h. die Diffusionssperre und die darauf aufgebrachte Schicht aus Gold oder dem Platinmetall, sind ebenfalls detailliert in den beiden deutschen Patentanmeldungen "Kühlbare Hochfrequenz-Luftspule" mit dem amtlichen Aktenzeichen 100 08 484.2 sowie "Hochfrequenz-Luftkondensator" mit dem amtlichen Aktenzeichen 100 08 483.4 der Firma CCR GmbH Beschichtungstechnologie beschrieben.

Einzelne oder alle hochfrequenz-führenden Komponenten des Anpaßnetzwerkes können mit einem flüssigen Medium, vorzugsweise mit Wasser, gekühlt werden.

Mit dem erfindungsgemäßen Anpaßnetzwerk, das zur Erzeugung eines quasineutralen Plasmastrahls oder Ionenstrahls verwendet werden kann, kann insbesondere die rein induktive Anregung optimiert werden, was zu einer beträchtlich höheren Anregungseffizienz führt. Außerdem wird dadurch die Ausnutzung spezieller Resonanzanregungen wie die Elektronen-Zyklotronen-Wellenresonanz oder die Landau-Dämpfungsresonanz ermöglicht.

Verwendet werden kann das erfindungsgemäße Hochfrequenz-Anpaßnetzwerk beispielsweise in einer Hochfrequenz-Plasma- oder -Ionenquelle wie in der deutschen Patentanmeldung "Hochfrequenz-Plasmaquelle" mit dem amtlichen Aktenzeichen 100 08 482.6 der Firma CCR GmbH Beschichtungstechnologie beschrieben.

Im folgenden wird die Erfindung beispielhaft anhand von Zeichnungen verdeutlicht:
- Figur 1: zeigt eine mögliche Verschaltung des Impedanz-Anpaßnetzwerkes
- Figur 2: zeigt eine Variante des Impedanz-Anpaßnetzwerkes
- Figur 3: zeigt ein System zur Übertragung des elektrischen Wechselfeldes ins Vakuum
- Figur 4: zeigt eine weitere Variante des Impedanz-Anpaßnetzwerkes
- Figur 5: zeigt den Schichtaufbau der hochfrequenz-führenden Komponenten
- Figur 6: zeigt segmentierte Stator- oder Rotorplatten
- Figur 7: zeigt den schematischen Aufbau eines zweifach-linearen Differential-Trimmers
- Figur 8: zeigt einen Vergleich von linearer und zweifach-linearer Kennlinie
- Figur 9: zeigt eine spiralförmig gewickelte Hochfrequenz-Luftspule
- Figur 10: zeigt eine spiralförmig gewickelte und sphärisch gewölbte Hochfrequenz- Luftspule

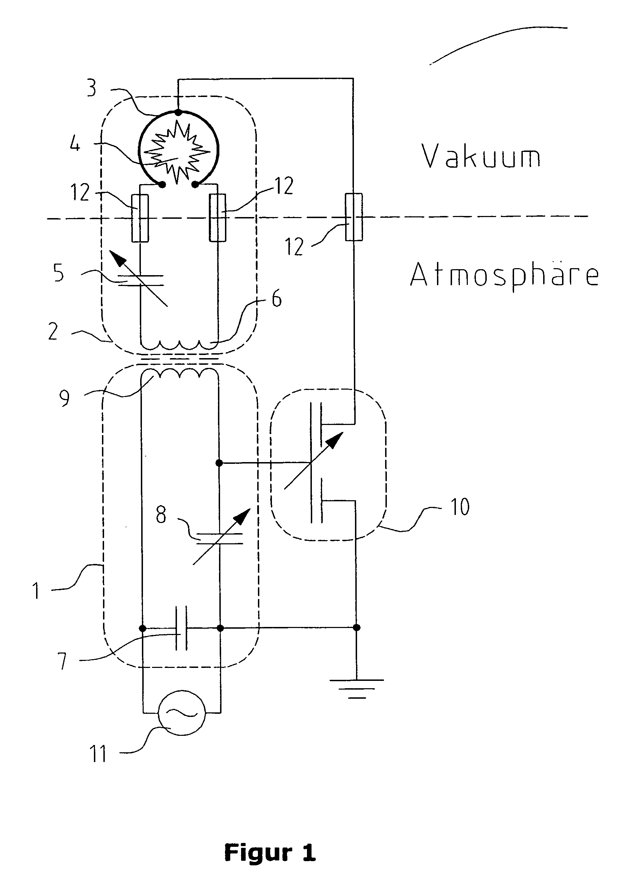

Die Schaltung des Anpaßnetzwerks in Figur 1 besteht aus zwei gekoppelten Schwingkreisen, dem Primär- (1) sowie dem Sekundärkreis (2). Die Leistung des Hochfrequenz-Generators (11) wird in den Primärkreis (1) eingespeist. Im Sekundärkreis (2) befindet sich eine im Vakuum liegende Anregungselektrode (3) zur Erzeugung des Plasmas. Dabei wird die Anregungselektrode (3) mit dem Sekundärkreis (2) über zwei Vakuumstromdurchführungen (12) verbunden. Die Kopplung beider Schaltkreise (1, 2) erfolgt sowohl induktiv mittels eines Übertragers bestehend aus zwei Hochfrequenz-Luftspulen (9, 6), als auch kapazitiv mittels eines Differential-Trimmers (10). Der Primärkreis (1) besteht aus einer Primärspule (9), einem beliebigen (7) und einem variablen Kondensator (Primärtrimmer) (8). Der Kondensator (7) liegt parallel zum Ausgang des Hochfrequenz-Generators, wobei üblicherweise ein Pol des Hochfrequenz-Generators (11) auf Massepotential geschaltet ist. Ebenfalls parallel zum Ausgang des Hochfrequenz-Generators (11) liegt die Reihenschaltung aus Primärtrimmer (8) und Primärspule (9), wobei der Primärtrimmer (8) mit dem Massepol des Hochfrequenz-Generators (11) verbunden ist. Der Sekundärkreis besteht aus der Reihenschaltung der Sekundärspule (6), einem variablen Kondensator (Sekundär-trimmer) (5) und der Anregungselektrode (3). Der Zentralpol des Differential-Trimmers ist dabei zwischen der Primärspule (9) und dem Primärtrimmer (8) angeschlossen. Die Seitenpole des Differential-Trimmers (10) sind auf Massepotential gelegt bzw. mit dem Zentralpol der Anregungselektrode (3) verbunden. Bei Bedarf können zusätzlich Festkondensatoren parallel zu allen Trimmern geschaltet werden.

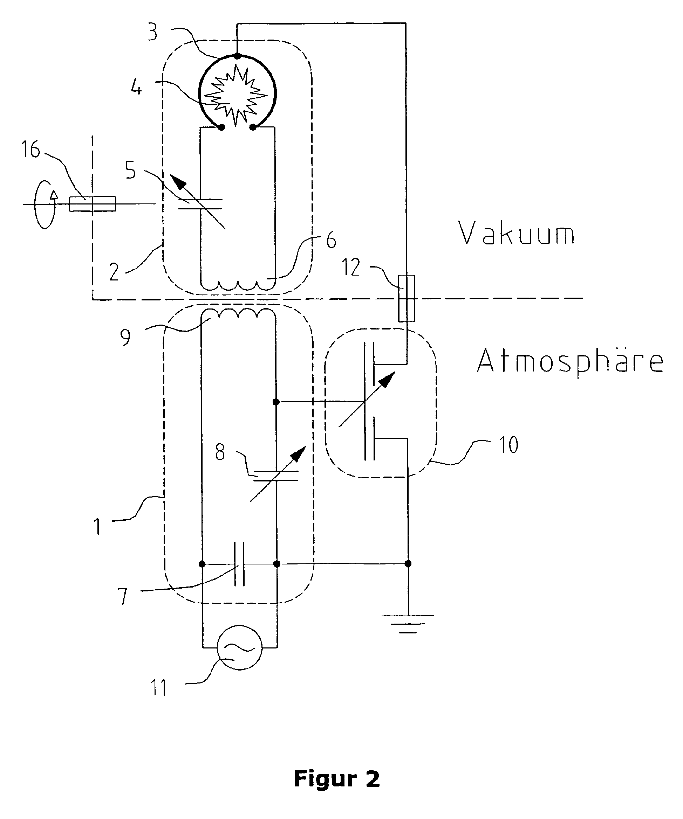

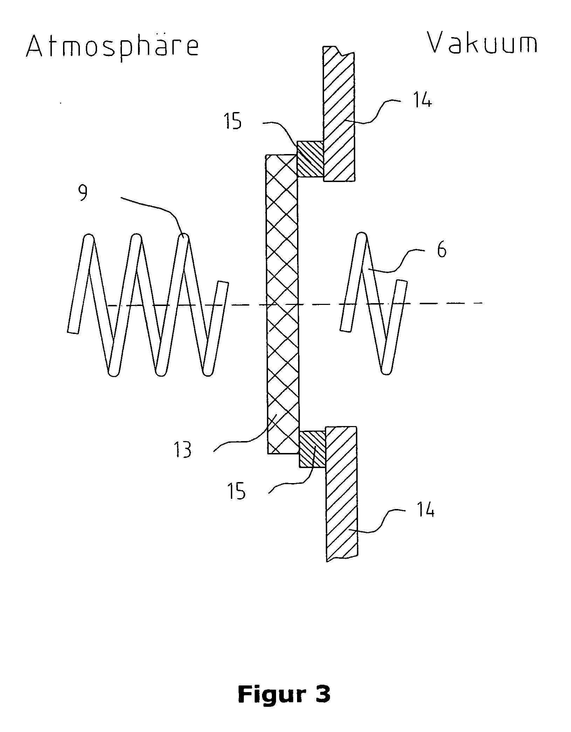

Figur 2 zeigt eine Variante des in Figur 1 dargestellten Anpaßnetzwerks, in der der gesamte Sekundärkreis (2) im Vakuum angeordnet ist. Die Trennung zwischen Vakuum und Atmosphäre erfolgt zwischen den beiden über den Induktionsfluß gekoppelten Luftspulen (6, 9) des Primär- bzw. Sekundärkreises (1, 2). Zur Trennung von Vakuum und Atmosphäre wird ein dielektrisches Fenster (13) verwendet (Figur 3), welches den Induktionsfluß der beiden Kopplungsspulen (6, 9) nicht unterbricht. Zwischen dem Fenster (13) und der Rückwand des Plasmagefäßes (14) ist eine Vakuumdichtung (15) angeordnet. Die Abstimmung des Sekundärkreises durch den Trimmer (5) erfolgt nun mittels einer mechanischen Vakuumdurchführung (16).

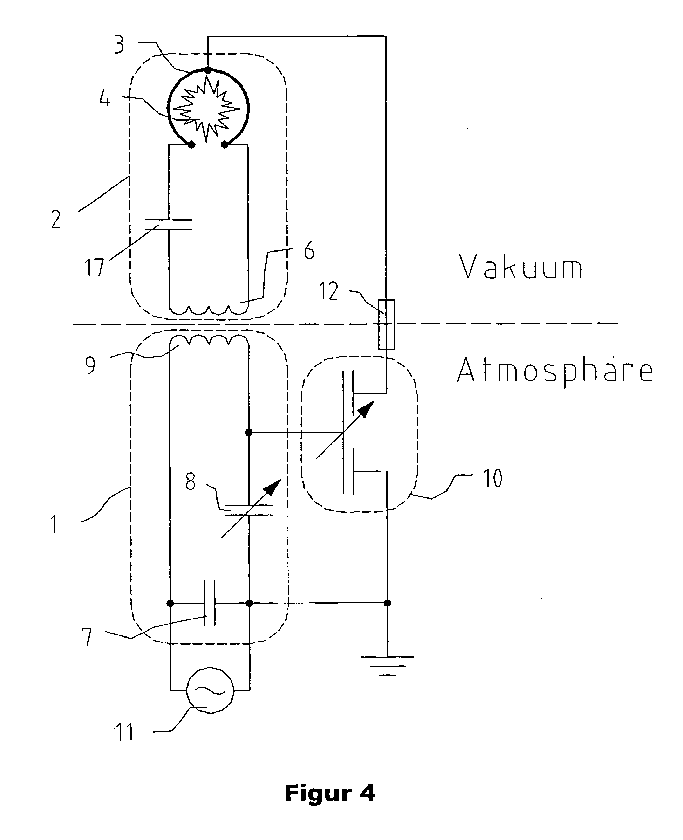

Figur 4 zeigt eine weiterentwickelte Variante des Anpaßnetzwerkes, in der der Sekundär-trimmer (5) durch einen Festkondensator (17) ersetzt wurde und die Abstimmung der Schwingkreise durch den Primärtrimmer (8) sowie durch Variation der induktiven Kopplung zwischen Primär- (9) und Sekundärspule (6) erfolgt. Hierzu wird der axiale und radiale Abstand zwischen der Primär- (9) und Sekundärspule (6) variiert, indem Komponenten des atmosphärenseitigen Anpaßnetzwerkes beweglich gelagert werden. Die Verbindung zwischen beweglich gelagerten und fest fixierten Komponenten des Primärkreises erfolgt dabei über flexible Leiterbahnen oder Hochfrequenz-Kabel.

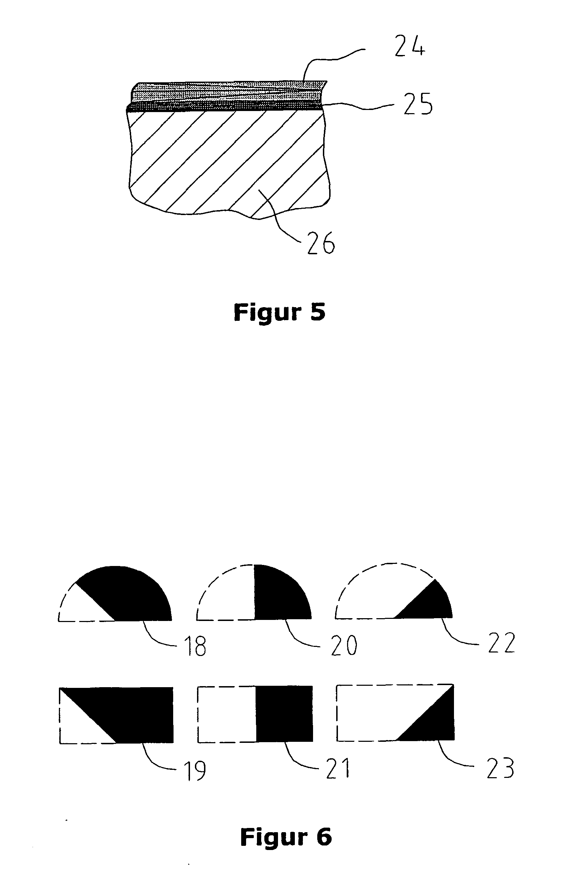

Figur 5 zeigt den Schichtaufbau der hochfrequenz-führenden Komponenten des Anpaßnetzwerkes. Das Basismaterial der Komponenten (26) ist mit einer geschlossenen als Diffusionssperre dienenden Nickelschicht (25) versehen. Auf diese Schicht ist eine Schicht aus Gold (24) aufgebracht.

Figur 6 zeigt eine Auswahl segmentierter Trimmer-Platten eines Differential-Luftplattentrimmers mit multi-linearer Kennlinie. Die dargestellten 135°-Segmente (18, 19), 90°-Segmente (20, 21) und 45°-Segmente (22, 23) sind zum Erreichen einer multi-linearen Abhängigkeit zusätzlich zu den herkömmlichen Trimmer-Platten erforderlich.

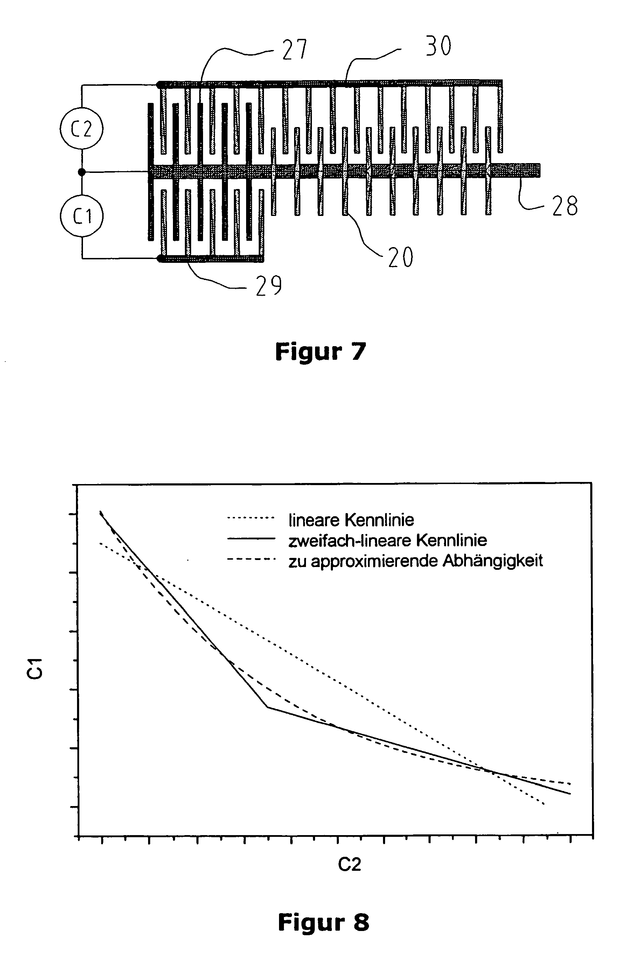

Figur 7 zeigt als Beispiel für einen multi-linearen Differential-Luftplattentrimmers einen zweifach-linearen Differential-Trimmer. Er besteht aus einer drehbaren Welle (28), auf der der Rotor angeordnet ist. Der Rotor ist aus fünf herkömmlichen 180°-Kreissegmenten (27) sowie aus zehn 90°-Segmenten (20) aufgebaut. Die Statorseite C1 besteht aus fünf herkömmlichen Statorplatten, die auf dem Statorträger (29) angebracht sind. Die Statorseite C2 besteht aus fünfzehn herkömmlichen Statorplatten, die auf dem zweiten Statorträger (30) angebracht sind. Die 90°-Rotor-Segmente (20) sind derart angeordnet, daß diese nur die Statorplatten der Statorseite C2 überstreichen. In analoger Weise können auch die Statorplatten als Teilsegmente gestaltet sein, um eine multi-lineare Kennlinie des Trimmers zu erhalten.

In Figur 8 ist die Kennlinie eines zweifach-linearen Differential-Luftplattentrimmers, d.h. Statorseite C1 in Abhängigkeit von Statorseite C2, dargestellt. Die Kennlinie setzt sich aus zwei Teilgeraden unterschiedlicher Steigung zusammen. Durch diesen zweifach-linearen Differential-Trimmer kann, verglichen mit einem herkömmlichen mit linearer Kennlinie, die dargestellte nicht-lineare Abhängigkeit mit erhöhter Genauigkeit angenähert werden.

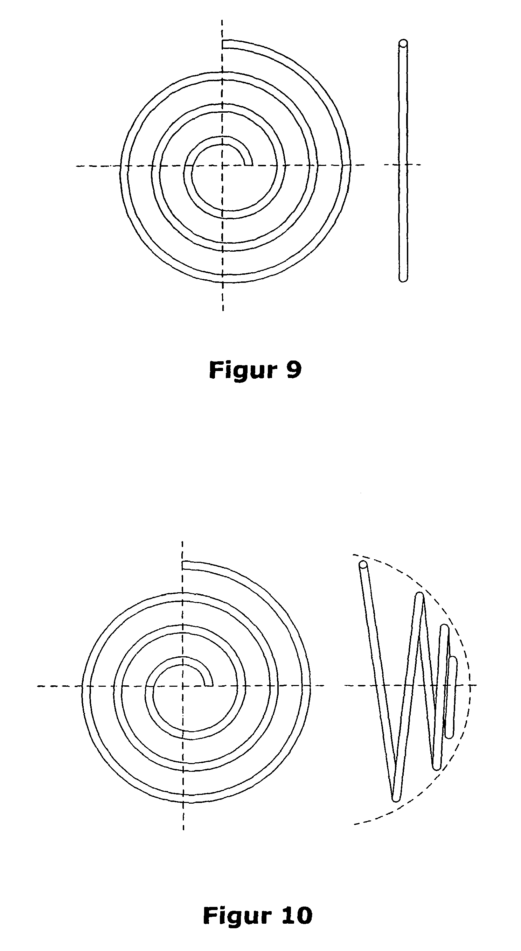

Die Figuren 9 und 10 zeigen mögliche Bauformen von Hochfrequenz-Luftspulen gemäß der Erfindung. Diese bestehen vorzugsweise aus einem spiralförmig (Figur 9) gewickelten Metallrohr. Die spiralförmig gewickelte Spule kann zusätzlich auch sphärisch gewölbt sein (Figur 10).

### Bezugszeichenliste:

- 1: primärer Schaltkreis des Impedanz-Anpaßnetzwerks
- 2: sekundärer Schaltkreis des Impedanz-Anpaßnetzwerks
- 3: Anregungselektrode
- 4: Plasma
- 5: variabler Kondensator (Trimmer)
- 6: Hochfrequenz-Luftspule
- 7: Kondensator
- 8: variabler Kondensator (Trimmer)
- 9: Hochfrequenz-Luftspule
- 10: Differential-Trimmer
- 11: Hochfrequenz-Generator
- 12: Vakuumstromdurchführung
- 13: dielektrisches Fenster
- 14: Rückwand des Plasmagefäßes
- 15: Vakuumdichtung
- 16: mechanische Vakuumdurchführung
- 17: Festkondensator
- 18: segmentierte Trimmer-Platte (135°-Kreissegment)
- 19: segmentierte Trimmer-Platte (135°-Rechtecksegment)
- 20: segmentierte Trimmer-Platte (90°-Kreissegment)
- 21: segmentierte Trimmer-Platte (90°-Rechtecksegment)
- 22: segmentierte Trimmer-Platte (45°-Kreissegment)
- 23: segmentierte Trimmer-Platte (45°-Rechtecksegment)
- 24: Schicht aus Gold
- 25: Diffusionssperre aus Nickel
- 26: Basismaterial der hochfrequenz-führenden Komponente
- 27: herkömmliche Rotor-Platte (180°-Kreissegment)
- 28: drehbare Welle
- 29: Statorträger
- 30: Statorträger

## Patentansprüche

1. Hochfrequenz-Anpaßnetzwerk bestehend aus
- einem primären Schaltkreis (1) mit einem beliebigen (7) und einem variablen Kondensator (8) und einer Hochfrequenz-Luftspule (9) sowie
- einem sekundären Schaltkreis (2) mit einem beliebigen Kondensator (5, 17), einer Hochfrequenz-Luftspule (6) und mindestens einer Anregungselektrode (3),
wobei die Schaltkreise (1, 2) über den induktiven Fluß der Hochfrequenz-Luftspulen (6, 9) miteinander gekoppelt sind,
**dadurch gekennzeichnet, daß** Primär- (1) und Sekundärkreis (2) zusätzlich auch kapazitiv durch einen oder mehrere kondensatoren gekoppelt sind.

2. Hochfrequenz-Anpaßnetzwerk nach Anspruch 1, **dadurch gekennzeichnet, daß** zwischen kapazitiver und induktiver Plasmaankopplung gewählt werden kann.

3. Hochfrequenz-Anpaßnetzwerk nach Anspruch 1 oder 2, **dadurch gekennzeichnet, daß** kontinuierlich zwischen kapazitiver und induktiver Plasmaankopplung gewählt werden kann.

4. Hochfrequenz-Anpaßnetzwerk nach einem der Ansprüche 1 bis 3, **dadurch gekennzeichnet, daß** die kapazitive Kopplung durch einen oder mehrere Fest-Kondensatoren erfolgt.

5. Hochfrequenz-Anpaßnetzwerk nach einem der Ansprüche 1 bis 4, **dadurch gekennzeichnet, daß** die kapazitive Kopplung durch einen variablen Kondensator erfolgt.

6. Hochfrequenz-Anpaßnetzwerk nach einem der Ansprüche 1 bis 5, **dadurch gekennzeichnet, daß** die kapazitive Kopplung durch einen Differential-Trimmer (10) erfolgt.

7. Hochfrequenz-Anpaßnetzwerk nach Anspruch 6, **dadurch gekennzeichnet, daß** als Differential-Trimmer (10) ein Differential-Luftplattentrimmer verwendet wird, der zur Erzielung einer multi-linearen Kennlinie eine Kombination von herkömmlichen und segmentierten Stator- und/oder Rotorplatten aufweist.

8. Hochfrequenz-Anpaßnetzwerk nach einem der Ansprüche 1 bis 7, **dadurch gekennzeichnet, daß** die Resonanzfrequenz von Primär- (1) und Sekundärkreis (2) auf die Generatorfrequenz über einen Primär- (8) sowie einen Sekundär-Trimmer (5) angepaßt werden kann.

9. Hochfrequenz-Anpaßnetzwerk nach einem der Ansprüche 1 bis 8, **dadurch gekennzeichnet, daß** parallel zu den Trimmern (5, 8) zusätzlich Fest-Kondensatoren geschaltet werden können.

10. Hochfrequenz-Anpaßnetzwerk nach einem der Ansprüche 1 bis 9, **dadurch gekennzeichnet, daß** der Primärkreis (1) derart dimensioniert ist, daß hohe Spannungsamplituden erreicht werden, und daß der Sekundärkreis (2) derart dimensioniert ist, daß hohe Stromamplituden erreicht werden.

11. Hochfrequenz-Anpaßnetzwerk nach einem der Ansprüche 1 bis 10, **dadurch gekennzeichnet, daß** die Primärspule (9) aus mehreren, vorzugsweise aus 2 bis 10 Wicklungen, besteht.

12. Hochfrequenz-Anpaßnetzwerk nach einem der Ansprüche 1 bis 11, **dadurch gekennzeichnet, daß d**ie Sekundärspule (6) aus weniger als 2 Wicklungen, vorzugsweise aus nur einer Wicklung, besteht.

13. Hochfrequenz-Anpaßnetzwerk nach einem der Ansprüche 1 bis 12, **dadurch gekennzeichnet, daß** der Durchmesser der Spulen (6, 9) zwischen 10 und 100 mm liegt.

14. Hochfrequenz-Anpaßnetzwerk nach einem der Ansprüche 1 bis 13, **dadurch gekennzeichnet, daß** eine Anregungselektrode (3) im Vakuum angeordnet ist.

15. Hochfrequenz-Anpaßnetzwerk nach einem der Ansprüche 1 bis 14, **dadurch gekennzeichnet, daß** die Anregungselektrode (3) mit dem atmosphärenseitigen Teil des Sekundärkreises (2) über Vakuumstromdurchführungen (12) verbunden ist.

16. Hochfrequenz-Anpaßnetzwerk nach einem der Ansprüche 1 bis 15, **dadurch gekennzeichnet, daß** der gesamte aus Trimmer (5), Spule (6) und Anregungselektrode (3) sowie den Verbindungselementen bestehende Sekundärkreis (2) im Vakuum angeordnet ist.

17. Hochfrequenz-Anpaßnetzwerk nach Anspruch 16 **dadurch gekennzeichnet, daß** zwischen den beiden Kopplungsspulen (6, 9) ein dielektrisches Fenster (13) angeordnet ist.

18. Hochfrequenz-Anpaßnetzwerk nach Anspruch 16 oder 17, **dadurch gekennzeichnet, daß** das dielektrische Fenster (13) aus einem unmagnetischen und magnetisch durchlässigen Material besteht.

19. Hochfrequenz-Anpaßnetzwerk nach einem der Ansprüche 16 bis 18, **dadurch gekennzeichnet, daß** das dielektrische Fenster (13) aus Quarzglas oder Aluminiumoxid besteht.

20. Hochfrequenz-Anpaßnetzwerk nach einem der Ansprüche 1 bis 19, **dadurch gekennzeichnet, daß** der Sekundär-Trimmer (5) durch eine mechanische Vakuumdurchführung (16) einstellbar ist.

21. Hochfrequenz-Anpaßnetzwerk nach einem der Ansprüche 1 bis 20, **dadurch gekennzeichnet, daß** der Sekundärkreis (2) mindestens aus einem Festkondensator (17), einer Hochfrequenz-Luftspule (6) und einer Anregungselektrode (3) besteht.

22. Hochfrequenz-Anpaßnetzwerk nach einem der Ansprüche 1 bis 21, **dadurch gekennzeichnet, daß** die Resonanz-Kreise durch Variation der induktiven Kopplung zwischen Primär- (9) und Sekundärspule (6) und/oder durch Einstellen des Primär-Trimmers (8) abstimmbar sind.

23. Hochfrequenz-Anpaßnetzwerk nach einem der Ansprüche 1 bis 22, **dadurch gekennzeichnet, daß** die Kopplung durch Variation des axialen und radialen Abstandes von Primär- (9) und Sekundärspule (6) einstellbar ist.

24. Hochfrequenz-Anpaßnetzwerk nach einem der Ansprüche 1 bis 23, **dadurch gekennzeichnet, daß** einzelne oder alle hochfrequenz-führenden Komponenten des Anpaßnetzwerkes, insbesondere Verbindungselemente, Leiterbahnen, Hochfrequenz-Luftspulen, Kondensatoren, Vakuumstromdurchführungen und Anregungsspulen, aus einem unedlen Metall mit geringem elektrischen Widerstand bestehen und mindestens an ihrer äußeren Oberfläche mit einer Schicht aus Gold- oder einem Platinmetall versehen sind.

25. Hochfrequenz-Anpaßnetzwerk nach einem der Ansprüche 1 bis 24, **dadurch gekennzeichnet, daß** zwischen dem unedlen Metall der hochfrequenz-führenden Komponenten und der Schicht aus Gold- oder dem Platinmetall eine Diffusionssperre (30) als geschlossene Schicht aufgetragen ist.

26. Hochfrequenz-Anpaßnetzwerk nach einem der Ansprüche 1 bis 25, **dadurch gekennzeichnet, daß** einzelne oder alle hochfrequenz-führenden Komponenten des Impedanz-Anpaßnetzwerkes mit einem flüssigen Medium, vorzugsweise mit Wasser, gekühlt werden.

27. Verwendung eines Hochfrequenz-Anpaßnetzwerks nach einem der Ansprüche 1 bis 26 zur Erzeugung eines quasineutralen Plasmastrahls.

28. Verwendung eines Hochfrequenz-Anpaßnetzwerks nach einem der Ansprüche 1 bis 26 zur Erzeugung eines Ionenstrahls.

## Claims

1. Radio-frequency matching network comprising
- a primary circuit (1) having any desired capacitor (7) and having a variable capacitor (8), and having a radio-frequency air-cord coil (9), as well as
- a secondary circuit (2) having any desired capacitor (5, 17), a radio-frequency air-cord coil (6) and at least one excitation electrode (3),
wherein the circuits (1, 2) are coupled to one another via the inductive flux of the radio-frequency air-cord coils (6, 9),
**characterized in that** the primary circuit (1) and the secondary circuit (2) are additionally also capacitively coupled by one or more capacitors.

2. Radio-frequency matching network according to Claim 1, **characterized in that** a choice can be made between capacitive and inductive plasma coupling.

3. Radio-frequency matching network according to Claim 1 or 2, **characterized in that** a choice can be made continuously between capacitive and inductive plasma coupling.

4. Radio-frequency matching network according to one of Claims 1 to 3, **characterized in that** the capacitive coupling is provided by one or more fixed capacitors.

5. Radio-frequency matching network according to one of Claims 1 to 4, **characterized in that** the capacitive coupling is provided by a variable capacitor.

6. Radio-frequency matching network according to one of Claims 1 to 5, **characterized in that** the capacitive coupling is provided by a differential trimmer (10).

7. Radio-frequency matching network according to Claim 6, **characterized in that** a differential air plate trimmer is used as the differential trimmer (10) and has a combination of conventional and segmented stator and/or rotor plates in order to achieve a multilinear characteristic.

8. Radio-frequency matching network according to one of Claims 1 to 7, **characterized in that** the resonant frequency of the primary circuit (1) and secondary circuit (2) can be matched to the generator frequency via a primary trimmer (8) and a secondary trimmer (5).

9. Radio-frequency matching network according to one of Claims 1 to 8, **characterized in that** fixed capacitors can additionally be connected in parallel with the trimmers (5, 8).

10. Radio-frequency matching network according to one of Claims 1 to 9, **characterized in that** the primary circuit (1) is designed such that high voltage amplitudes are achieved, and **in that** the secondary circuit (2) is designed such that high current amplitudes are achieved.

11. Radio-frequency matching network according to one of Claims 1 to 10, **characterized in that** the primary coil (9) comprises a plurality of winding, preferably 2 to 10 windings.

12. Radio-frequency matching network according to one of Claims 1 to 11, **characterized in that** the secondary coil (6) comprises fewer than 2 windings, preferably only one winding.

13. Radio-frequency matching network according to one of Claims 1 to 12, **characterized in that** the diameter of the coils (6, 9) is between 10 and 100 mm.

14. Radio-frequency matching network according to one of Claims 1 to 13, **characterized in that** an excitation electrode (3) is arranged in a vacuum.

15. Radio-frequency matching network according to one of Claims 1 to 14, **characterized in that** the excitation electrode (3) is connected via vacuum current bushings (12) to the part of the secondary circuit (2) on the atmosphere side.

16. Radio-frequeucy matching network according to one of Claims 1 to 15, **characterized in that** the entire secondary circuit (2), comprising the trimmer (5), the coil (6) and the excitation electrode (3) as well as the connecting elements, is arranged in a vacuum.

17. Radio-frequency matching network according to Claim 16, **characterized in that** a dielectric window (13) is arranged between the two coupling coils (6, 9).

18. Radio-frequency matching network according to Claim 16 or 17, **characterized in that** the dielectric window (13) is composed of a non-magnetic and magnetically permeable material.

19. Radio-frequency matching network according to one of Claims 16 to 18, **characterized in that** the dielectric window (13) is composed of quartz glass or aluminium oxide.

20. Radio-frequency matching network according to one of Claims 1 to 19, **characterized in that** the secondary trimmer (5) can be adjusted through a mechanical vacuum bushing (16).

21. Radio-frequency matching network according to one of Claims 1 to 20, **characterized in that** the secondary circuit (2) comprises at least one fixed capacitor (17), one radio-frequency air-cord coil (6), and one excitation electrode (3).

22. Radio-frequency matching network according to one of Claims 1 to 21, **characterized in that** the resonant circuits can be tuned by variation of the inductive coupling between the primary coil (9) and the secondary coil (6), and/or by adjusting the primary trimmer (8).

23. Radio-frequency matching network according to one of Claims 1 to 22, **characterized in that** the coupling can be adjusted by variation of the axial and radial distance between the primary coil (9) and the secondary coil (6).

24. Radio-frequency matching network according to one of Claims I to 23, **characterized in that** individual components, or all the components which carry radio frequency, of the matching network, in particular connecting elements, conductor tracks, radio-frequency air-cord coils, capacitors, vacuum current bushings and excitation coils, are composed of a base metal of low electrical resistance, and are provided at least on their outer surface with a layer composed of gold metal or a platinum metal.

25. Radio-frequency matching network according to one of Claims I to 24, **characterized in that** a diffusion barrier (30) is applied as a closed layer between the base metal of the components which carry radio frequency and the layer composed of gold metal or the platinum metal.

26. Radio-frequency matching network according to one of Claims 1 to 25, **characterized in that** individual components or all the components which carry radio frequency, of the impedance matching network are cooled by a liquid medium, preferably by water.

27. Use of a radio-frequency matching network according to one of Claims 1 to 26 for production of a quasi-neutral plasma bream.

28. Use of a radio-frequency matching network according to one of Claims 1 to 26 for production of an ion beam.

## Revendications

1. Réseau d'adaptation à haute fréquence constitué
- d'un circuit primaire (1) comprenant un condensateur quelconque (7) et un variable (8) ainsi qu'une bobine à air à haute fréquence (9) et
- d'un circuit secondaire (2) comprenant un condensateur quelconque (5, 17), une bobine à air à haute fréquence (6) et au moins une électrode d'excitation (3),
les circuits (1, 2) étant couplés l'un à l'autre par le biais du flux inductif des bobines à air à haute fréquence (6, 9),
**caractérisé en ce que** le circuit primaire (1) et secondaire (2) sont en plus également couplés de manière capacitive par un ou plusieurs condensateurs.

2. Réseau d'adaptation à haute fréquence selon la revendication 1, **caractérisé en ce qu'**il est possible de choisir entre un couplage plasma capacitif et inductif.

3. Réseau d'adaptation à haute fréquence selon la revendication 1 ou 2, **caractérisé en ce qu'**il est possible de choisir continuellement entre un couplage plasma capacitif et inductif.

4. Réseau d'adaptation à haute fréquence selon l'une des revendications 1 à 3, **caractérisé en ce que** le couplage capacitif est réalisé par un ou plusieurs condensateurs fixes.

5. Réseau d'adaptation à haute fréquence selon l'une des revendications 1 à 4, **caractérisé en ce que** le couplage capacitif est réalisé par un condensateur variable.

6. Réseau d'adaptation à haute fréquence selon l'une des revendications 1 à 5, **caractérisé en ce que** le couplage capacitif est réalisé par un condensateur ajustable différentiel (10).

7. Réseau d'adaptation à haute fréquence selon la revendication 6, **caractérisé en ce que** le condensateur ajustable différentiel (10) utilisé est un condensateur ajustable différentiel à lames qui, pour obtenir une courbe caractéristique linéaire multiple, présente une combinaison de lames de stator et/ou de rotor classiques et segmentées.

8. Réseau d'adaptation à haute fréquence selon l'une des revendications 1 à 7, **caractérisé en ce que** la fréquence de résonance du circuit primaire (1) et secondaire (2) peut être adaptée à la fréquence du générateur par le biais d'un condensateur ajustable primaire (8) et d'un secondaire (5).

9. Réseau d'adaptation à haute fréquence selon l'une des revendications 1 à 8, **caractérisé en ce que** des condensateurs fixes peuvent en plus être branchés en parallèle avec les condensateurs ajustables (5, 8).

10. Réseau d'adaptation à haute fréquence selon l'une des revendications 1 à 9, **caractérisé en ce que** le circuit primaire (1) est dimensionné de telle sorte que des amplitudes de tension élevées sont atteintes et que le circuit secondaire (2) est dimensionné de telle sorte que des amplitudes de courant élevées sont atteintes.

11. Réseau d'adaptation à haute fréquence selon l'une des revendications 1 à 10, **caractérisé en ce que** la bobine primaire (9) se compose de plusieurs enroulements, de préférence de 2 à 10.

12. Réseau d'adaptation à haute fréquence selon l'une des revendications 1 à 11, **caractérisé en ce que** la bobine secondaire (6) se compose de moins de 2 enroulements, de préférence d'un seul enroulement.

13. Réseau d'adaptation à haute fréquence selon l'une des revendications 1 à 12, **caractérisé en ce que** le diamètre des bobines (6, 9) est compris entre 10 et 100 mm.

14. Réseau d'adaptation à haute fréquence selon l'une des revendications 1 à 13, **caractérisé en ce qu'**une électrode d'excitation (3) est disposée dans le vide.

15. Réseau d'adaptation à haute fréquence selon l'une des revendications 1 à 14, **caractérisé en ce que** l'électrode d'excitation (3) est reliée avec la partie atmosphérique du circuit secondaire (2) par le biais de passages de courant sous vide (12).

16. Réseau d'adaptation à haute fréquence selon l'une des revendications 1 à 15, **caractérisé en ce que** l'ensemble du circuit secondaire (2) constitué du condensateur ajustable (5), de la bobine (6) et de l'électrode d'excitation (3) ainsi que des éléments de liaison est placé sous vide.

17. Réseau d'adaptation à haute fréquence selon la revendication 16, **caractérisé en ce qu'**une fenêtre diélectrique (13) se trouve entre les deux bobines de couplage (6, 9).

18. Réseau d'adaptation à haute fréquence selon la revendication 16 ou 17, **caractérisé en ce que** la fenêtre diélectrique (13) se compose d'un matériau amagnétique et magnétiquement perméable.

19. Réseau d'adaptation à haute fréquence selon l'une des revendications 16 à à 18, **caractérisé en ce que** la fenêtre diélectrique (13) se compose de verre de quartz ou d'oxyde d'aluminium.

20. Réseau d'adaptation à haute fréquence selon l'une des revendications 1 à 19, **caractérisé en ce que** le condensateur ajustable secondaire (5) peut être réglé par une traversée du vide (16) mécanique.

21. Réseau d'adaptation à haute fréquence selon l'une des revendications 1 à 20, **caractérisé en ce que** le circuit secondaire (2) se compose au moins d'un condensateur fixe (17), d'une bobine à air à haute fréquence (6) et d'une électrode d'excitation (3).

22. Réseau d'adaptation à haute fréquence selon l'une des revendications 1 à 21, **caractérisé en ce que** les circuits de résonance peuvent être accordés en faisant varier le couplage inductif entre la bobine primaire (9) et secondaire (6) et/ou en réglant le condensateur ajustable primaire (8).

23. Réseau d'adaptation à haute fréquence selon l'une des revendications 1 à 22, **caractérisé en ce que** le couplage est réglable en faisant varier l'écart axial et radial entre la bobine primaire (9) et secondaire (6).

24. Réseau d'adaptation à haute fréquence selon l'une des revendications 1 à 23, **caractérisé en ce que** certains ou la totalité des composants du réseau d'adaptation qui conduisent la haute fréquence, notamment les éléments de liaison, les pistes conductrices, les bobines à air à haute fréquence, les condensateurs, les passages de courant sous vide et les bobines d'excitation se composent d'un métal commun de faible résistance électrique et sont munis au moins sur leur surface extérieure d'une couche de métal à base d'or ou de platine.

25. Réseau d'adaptation à haute fréquence selon l'une des revendications 1 à 24, **caractérisé en ce qu'**un blocage de la diffusion (30) sous la forme d'une couche fermée est appliqué entre le métal commun des composants qui conduisent la haute fréquence et la couche de métal à base d'or ou de platine.

26. Réseau d'adaptation à haute fréquence selon l'une des revendications 1 à 25, **caractérisé en ce que** certaines ou la totalité des composants qui conduisent la haute fréquence du réseau d'adaptation d'impédance sont refroidis par un fluide liquide, de préférence avec de l'eau.

27. Utilisation d'un réseau d'adaptation à haute fréquence selon l'une des revendications 1 à 26 pour générer un jet de plasma quasi-neutre.

28. Utilisation d'un réseau d'adaptation à haute fréquence selon l'une des revendications 1 à 26 pour générer un jet d'ions.
